Europäisches Patentamt

European Patent Office

Office européen des brevets

(19)

(11) **EP 0 740 414 B1**

(12) **FASCICULE DE BREVET EUROPEEN**

(45) Date de publication et mention
de la délivrance du brevet:
**12.07.2000 Bulletin 2000/28**

(51) Int Cl.[7]: **H03H 17/06**, H03H 17/00

(21) Numéro de dépôt: **96400851.0**

(22) Date de dépôt: **22.04.1996**

(54) **Dispositif de retard programmable d'un signal analogique et antenne acoustique programmable correspondante**

Vorrichtung zur einstellbaren Verzögerung eines analogen Signals und entsprechende einstellbare akustische Antenne

Programmable delay device for analog signals and corresponding programmable acoustic antenna

(84) Etats contractants désignés:
**DE FR GB**

(30) Priorité: **25.04.1995 FR 9504918**

(43) Date de publication de la demande:
**30.10.1996 Bulletin 1996/44**

(73) Titulaire: **FRANCE TELECOM**
**75015 Paris (FR)**

(72) Inventeurs:
• **Le Tourneur, Grégoire**
**22700 Saint-Quay-Perros (FR)**

• **Balestro, Freddy**
**38000 Grenoble (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
**EP-A- 0 639 347          WO-A-94/19869**
**US-A- 3 997 772**

## Description

L'invention concerne un dispositif de retard programmable d'un signal analogique et ses applications, notamment aux antennes acoustiques programmables.

Dans les systèmes de prise de son actuels, des antennes acoustiques sont formées par plusieurs microphones, lesquels sont agencés de façon à effectuer une prise de son visant à n'apporter que de faibles dégradations au signal sonore. Dans ce but, un signal de retard pur programmable est introduit sur le signal délivré par chaque microphone, afin, soit de corriger la géométrie physique de l'antenne acoustique réalisée, soit de pointer le diagramme de réception de l'antenne acoustique dans une direction donnée par rapport à l'axe de symétrie de l'antenne acoustique. Les signaux retardés de façon appropriée pour chaque microphone sont alors sommés pour délivrer un signal résultant représentatif du signal sonore.

Une première solution, pour réaliser cette fonction de retard, consiste à insérer des lignes à retard analogiques en cascade avec chaque microphone. Cette solution présente toutefois les inconvénients et limitations des systèmes analogiques, c'est-à-dire précision et reproductibilité insuffisantes pour des applications professionnelles.

Une deuxième solution peut cependant consister, à partir d'un signal numérisé, soit après chaque microphone, soit après sommation, signal numérisé consistant en des échantillons successifs séparés par une période d'échantillonnage T, à mémoriser ces échantillons. La mémorisation de N échantillons successifs a en effet pour effet de retarder la transmission du signal, soumis à cette mémorisation, d'une durée de retard $\Delta = NxT$. Le retard $\Delta$ doit toutefois être supérieur à la durée de la période d'échantillonnage T, avec la précision souhaitée. Pour des fréquences d'échantillonnage de 16 kHz et 48 kHz, la période d'échantillonnage est égale à 62,5 µs respectivement 20,8 µs.

Dans certaines applications professionnelles spécifiques, les valeurs de période d'échantillonnage sont supérieures, avec une précision de 1 µs.

Dans un tel cas, il n'est pas possible d'appliquer le retard directement sur les échantillons issus de la conversion analogique/numérique.

Il est alors nécessaire d'élever la fréquence d'échantillonnage du signal délivré par les microphones, par suréchantillonnage. Pour une fréquence des échantillons, après suréchantillonnage, égale à $F_2$, la fréquence des échantillons avant suréchantillonnage étant égale à $F_1$, la durée de la période des échantillons après suréchantillonnage est divisée dans le rapport $K = F_2/F_1$. La valeur de ce rapport est déterminée par la valeur de $F_1$, fréquence d'échantillonnage, et par la précision recherchée pour le retard apporté.

Par exemple, pour $F_1$ = 16 kHz et pour une précision, retard minimum, $\Delta m$ = 1 µs, la valeur de K est K = 63.

La valeur retenue est la valeur, multiple de deux immédiatement supérieure, K = 64.

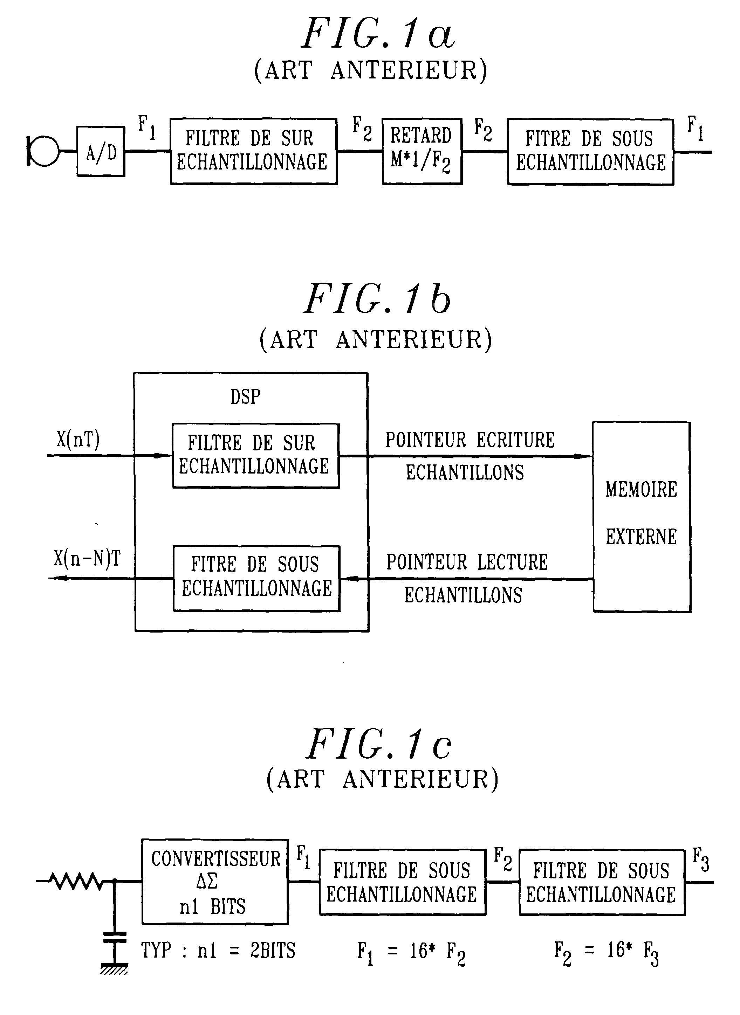

Un tel dispositif est représenté schématiquement en figure 1a) dans lequel $T_2 = 1/F_2$ est bien inférieur à 1 µs, le retard apporté $\Delta = M \times T_2$ correspondant à la mémorisation de M échantillons. Le passage du signal suréchantillonné retardé dans un filtre de sous-échantillonnage, de rapport 1/K, effectuant l'opération inverse, ramène le signal retardé à la fréquence d'échantillonnage $F_1$.

Un tel dispositif, décrit notamment dans le document US-A-3 997 772, permet d'introduire un retard programmé inférieur à la période d'échantillonnage. Toutefois, il n'existe pas de composant intégré susceptible de réaliser une telle fonction.

De manière générale, ainsi que représenté en figure 1b), il est nécessaire d'utiliser un processeur de signal numérique DSP pour mettre en oeuvre le filtre de suréchantillonnage, la gestion des échantillons dans la mémoire externe et le filtre de sous-échantillonnage. Le retard est obtenu par écriture des échantillons dans la mémoire externe et relecture d'échantillons mémorisés antérieurement. Le choix des filtres de sur- et sous-échantillonnage est important. Si ceux-ci sont choisis avec beaucoup de coefficients, la réponse en fréquence est parfaite, au prix d'une grande puissance de calcul (environ 4 MIPS -Mega Instructions Par Seconde- pour $F_1$ = 16 kHz et des filtres de 256 coefficients), bien qu'une réjection hors bande de 70 dB provoque tout de même une légère dégradation du signal.

Si, au contraire, ceux-ci sont choisis avec un nombre de coefficients réduits, 64 coefficients pour $F_1$ = 16 kHz, la puissance de calcul est certes réduite à 1 MIPS, mais la courbe de réponse est fortement dégradée, par la présence d'ondulations dans la bande passante et d'une mauvaise réjection hors bande, moins de 30 dB, entraînant une dégradation significative du signal.

Ainsi, pour une petite antenne acoustique comportant 10 microphones, la mise en oeuvre de tels circuits de retard nécessite une puissance de calcul comprise entre 10 et 40 MIPS. Pour une antenne acoustique comportant 64 microphones, antenne plus particulièrement destinée à des applications de visioconférence, la puissance de calcul nécessaire est comprise entre 64 et 256 MIPS, ce qui nécessite la mise en oeuvre de 2 à 6 DSP, processeur de signal numérique, auxquels il faut ajouter les mémoires externes de retard. Le coût de mise en oeuvre de telles antennes, même dans le cas de petites antennes, est donc très élevé.

Dans les techniques actuelles de conversion analogique/numérique, un convertisseur classique comprend habituellement un filtre analogique anti-repliement, conformément au théorème de Shannon, le signal obtenu, limité en fréquence, étant converti par approximation successive par rapport à une tension de référence. La précision du convertisseur dépend de la précision de la comparaison à la tension de référence. Ce type de dispositif nécessite un filtre analogique dont la fréquence de coupure est fonction de la fréquence d'échantillonnage, ce qui rend nécessaire le changement de filtre analogique lorsque l'on procède au changement de la fréquence d'échantillonnage. Ces convertisseurs sont donc d'un emploi peu souple.

Plus récemment, une autre catégorie de convertisseurs analogiques/numériques a été développée, ces convertisseurs comportant une pluralité d'étages de conversion en cascade pilotés chacun par une fréquence d'échantillonnage différente.

Un tel type de convertisseur est représenté en figure 1c), et correspond de manière non limitative à un convertisseur dit "*delta sigma*", noté convertisseur $\Delta\Sigma$.

Suite à un filtrage passe-bas analogique du premier ordre, un étage convertisseur quantifie le signal analogique filtré à une cadence élevée, $F_1$ = 4 MHz (4096 kHz) pour une fréquence d'échantillonnage $F_3$ = 16 kHz, sur un nombre de bits faible, 1, 2 ou 3 bits, grâce à un module de conversion $\Delta\Sigma$ reportant le bruit de quantification sur les hautes fréquences. Le signal converti est ramené à une fréquence intermédiaire, par exemple $F_1$ = $16*F_2$, soit $F_2$ = 256 kHz, au moyen d'un premier filtre passe-bas, sur un nombre plus important de bits, puis amené au format du signal échantillonné par passage dans un deuxième filtre de sous-échantillonnage, de type passe-bas, sur le nombre de bits final, 16 par exemple, et à la fréquence d'échantillonnage $F_3$ = 16 kHz. L'avantage de ce dispositif réside dans le fait que la fonction de filtrage anti-repliement est effectuée numériquement et que la fréquence de coupure est modifiée automatiquement en fonction de la fréquence d'échantillonnage finale, $F_3$, choisie.

De tels dispositifs de conversion analogique/numérique sont d'un emploi très souple, puisqu'il suffit d'appliquer directement le signal, issu d'un microphone par exemple, à l'entrée du filtre analogique, et de fournir la fréquence d'échantillonnage $F_3$, les fréquences $F_2$ et $F_1$ pouvant être déduites de celle-ci.

La présente invention a pour objet de remédier aux inconvénients précités des dispositifs de retard de l'art antérieur, notamment ceux inhérents à l'utilisation de processeurs de signal numérique.

Un autre objet de la présente invention est la mise en oeuvre d'un dispositif de retard à partir d'un convertisseur analogique/numérique comportant une pluralité d'étages de conversion en cascade pilotés chacun par une fréquence d'échantillonnage différente, ce qui permet d'introduire sur les échantillons les retards voulus, tout en supprimant la mise en oeuvre d'un ou plusieurs processeurs de signal numérique.

Un autre objet de la présente invention est la mise en oeuvre, à partir de tels dispositifs de retard, d'une antenne acoustique orientable ou compensée.

Le dispositif de retard programmable d'un signal analogique, objet de la présente invention, est remarquable en ce qu'il comprend, au moins, un circuit convertisseur analogique numérique sur un nombre réduit de bits recevant le signal analogique et délivrant un signal numérique, succession d'échantillons, à une première fréquence d'échantillonnage, une mémoire de retard recevant en écriture ce signal numérique et permettant la mémorisation de M échantillons consécutifs. Un module d'accès en écriture et en lecture de cette mémoire est prévu, et permet d'adresser en écriture et en lecture cette mémoire de retard avec une fréquence d'écriture et de lecture égale à la première fréquence d'échantillonnage, la mémoire de retard délivrant sur commande d'accès en lecture une suite d'échantillons retardés d'une valeur déterminée, fonction du nombre M d'échantillons mémorisés dans cette mémoire de retard, par rapport à la succession d'échantillons reçus pour écriture à l'entrée de la mémoire de retard, sous forme d'un signal numérique retardé. Un module de sous-échantillonnage reçoit le signal numérique retardé et délivre un signal numérique retardé sous-échantillonné à une deuxième fréquence d'échantillonnage, inférieure à la première fréquence d'échantillonnage.

Le dispositif de retard programmable d'un signal analogique objet de l'invention trouve application à la réalisation d'antennes acoustiques dédiées à des applications grand public ou professionnelles.

Il sera mieux compris à la lecture de la description et à l'observation des dessins ci-après dans lesquels, outre les figures 1a à 1c et 4a relatives à l'art antérieur,

-    la figure 2 représente un schéma synoptique d'un dispositif de retard programmable d'un signal analogique, objet de la présente invention ;
-    la figure 3a représente une première variante de réalisation du dispositif de retard objet de la présente invention mise en oeuvre pour plusieurs retards programmables individuellement ;
-    la figure 3b représente une deuxième variante de réalisation du dispositif de retard objet de la présente invention dans laquelle la taille mémoire de la mémoire de retard utilisée est rendue minimale ;
-    la figure 4a représente le schéma synoptique d'une antenne acoustique de l'art antérieur de type antenne-somme à angle de pointage variable, dite antenne acoustique à balayage électronique ;
-    la figure 4b représente le schéma synoptique d'une antenne acoustique à balayage électronique réalisée grâce à la mise en oeuvre d'une pluralité de dispositifs de retard programmables conformes à l'objet de la présente invention.

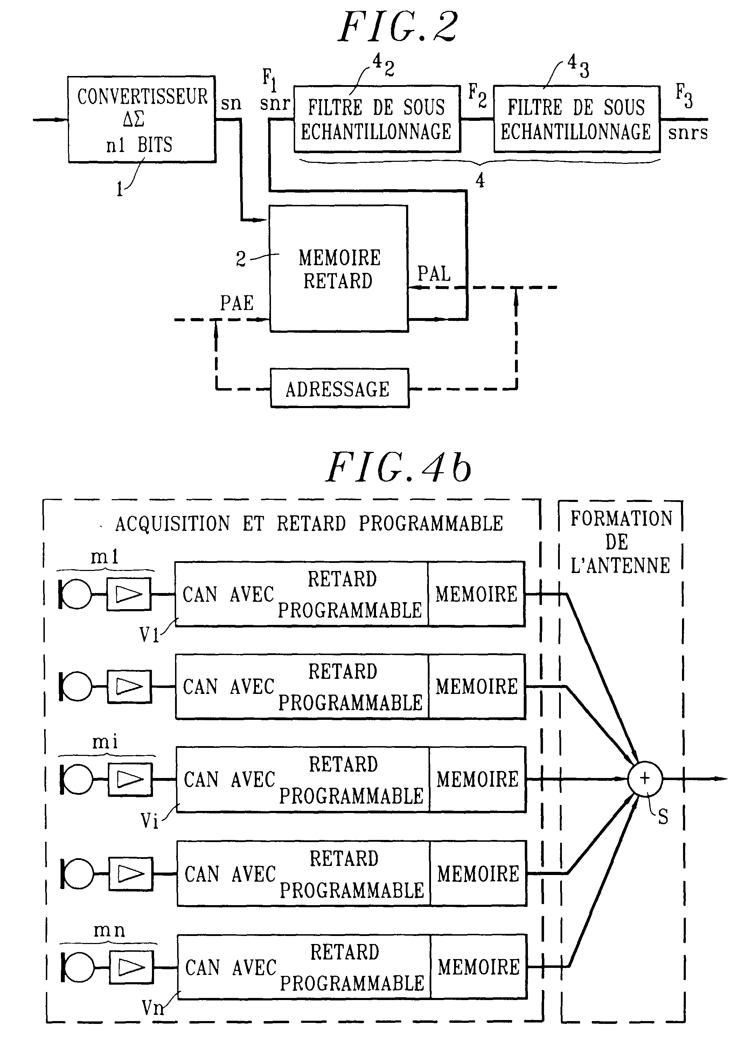

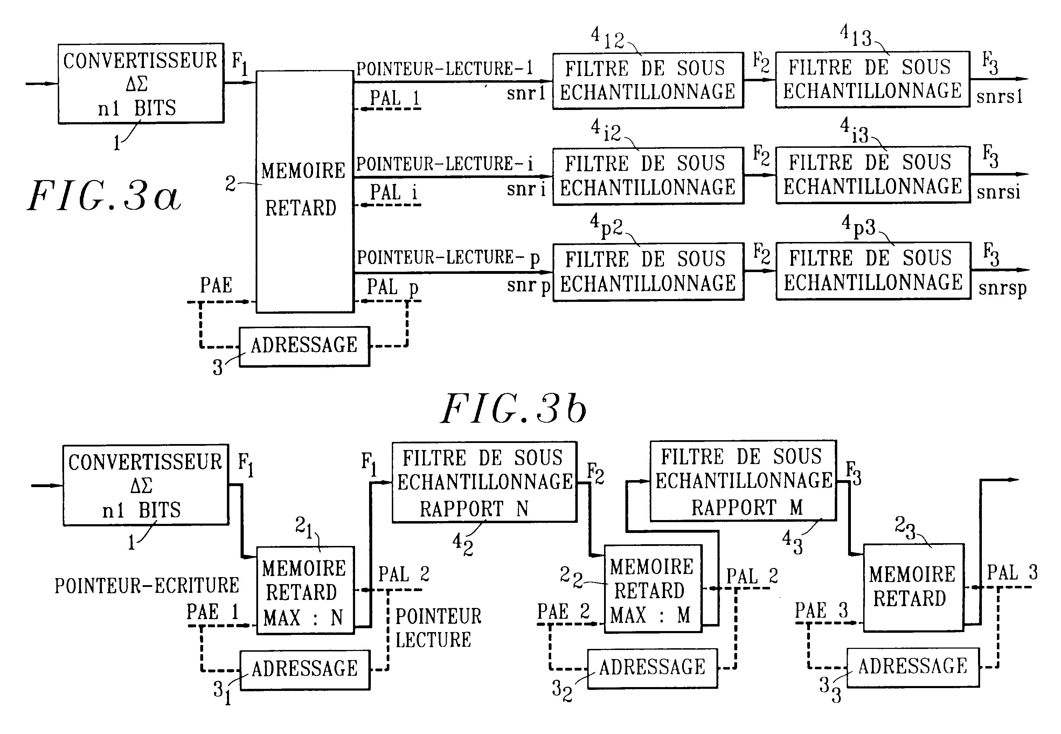

Une description plus détaillée d'un dispositif de retard programmable d'un signal analogique conforme à l'objet de la présente invention sera maintenant donnée en liaison avec la figure 2 et les figures suivantes.

Selon la figure 2 précitée, le dispositif de retard programmable, objet de l'invention, comprend au moins un circuit 1 convertisseur analogique/numérique recevant le signal analogique <u>sa</u> constituant signal d'entrée, et délivre un signal numérique <u>sn</u> à une première fré-

quence d'échantillonnage $F_1$, ce signal numérique étant constitué par une succession d'échantillons.

D'une manière générale, on indique que le circuit 1 convertisseur analogique/numérique effectue la conversion analogique/numérique sur un nombre réduit de bits, 2 à 3 bits par exemple, à une fréquence très élevée, supérieure à 1MHz.

Le dispositif de retard programmable, selon l'invention, comporte en outre en cascade avec le circuit 1 convertisseur analogique/numérique une mémoire de retard 2 recevant en écriture le signal numérique sn et permettant la mémorisation de M échantillons consécutifs.

Un module 3 d'accès en écriture et en lecture de la mémoire de retard 2 est prévu, ce module 3 permettant d'adresser en écriture et en lecture la mémoire de retard 2 avec une fréquence d'écriture et de lecture égale à la première fréquence d'échantillonnage $F_1$. La mémoire de retard 2 délivre, sur commande d'accès en lecture par le module 3 d'accès en écriture et en lecture, une suite d'échantillons retardés d'une valeur déterminée, fonction du nombre d'échantillons mémorisés M dans la mémoire de retard 2 par rapport à la succession d'échantillons reçus pour écriture à l'entrée de cette mémoire de retard 2.

Les échantillons retardés délivrés par la mémoire de retard 2 constituent un signal numérique retardé, noté snr.

En ce qui concerne le module 3 d'accès en écriture et en lecture, on indique que celui-ci peut être constitué par un module d'adressage d'un microcontrôleur, celui-ci délivrant des pointeurs d'accès en écriture, respectivement en lecture, représentés par des flèches en pointillé sur la figure 2 et référencés pae respectivement pal. Ce module d'adressage ne sera pas décrit plus en détail car il correspond à des spécifications connues de l'état de la technique.

En outre, le dispositif de retard programmable, selon l'invention, comprend un circuit 4 de sous-échantillonnage recevant le signal numérique retardé snr et délivrant un signal numérique retardé sous-échantillonné snrs à une fréquence d'échantillonnage inférieure à la première fréquence d'échantillonnage.

Dans un mode de réalisation spécifique du dispositif de retard programmable, objet de la présente invention, on indique que le circuit 1 convertisseur analogique/numérique est de préférence réalisé par un convertisseur comportant une pluralité d'étages de conversion en cascade pilotés chacun par une fréquence d'échantillonnage différente. De tels convertisseurs peuvent être réalisés sous la forme d'un convertisseur $\Delta\Sigma$. De manière plus particulière, on indique que le signal numérique sn délivré par ce type de convertisseur est celui délivré par le premier étage de ce convertisseur, le signal délivré par ce premier étage étant à une fréquence $F_1$ supérieure à la fréquence de sortie globale délivrée par le convertisseur $\Delta\Sigma$ global. On comprend ainsi que le signal numérique sn est délivré à une fréquence $F_1$ supérieure, ce qui permet d'obtenir des précisions meilleures pour le retard apporté par la mémoire de retard 2.

Du point de vue du fonctionnement, on indique que le circuit 3 d'accès en écriture et en lecture délivre simultanément à la mémoire de retard 2 le pointeur d'adresse en écriture pae et au moins un pointeur d'adresse en lecture pal, la différence des adresses des pointeurs précités étant égale au nombre M d'échantillons mémorisés. Le retard introduit par la mémoire de retard est alors égal au produit du nombre M d'échantillons mémorisés et de la période $T_1$, inverse de la première fréquence d'échantillonnage $F_1$, c'est-à-dire fréquence d'échantillonnage du signal numérique sn.

Dans le mode de réalisation du dispositif de retard programmable objet de la présente invention telle que représentée en figure 2, on indique que l'utilisation d'un processeur de signal numérique n'est plus nécessaire pour implanter les fonctions de sur- et sous-échantillonnage, ce qui entraîne une simplification notoire des coûts de réalisation.

En outre, le faible nombre de bits à mémoriser à la sortie du convertisseur $\Delta\Sigma$ diminue également la taille de mémoire à utiliser, typiquement de 16 bits à 2 bits lorsque la conversion est effectuée sur 2 bits, soit une diminution dans un rapport 8 de la taille de la mémoire de retard précitée.

En ce qui concerne la mémoire de retard 2, on indique que celle-ci peut être réalisée au moyen d'une mémoire circulaire de taille N à laquelle sont associés un pointeur d'écriture et au moins un pointeur de lecture.

Pour l'opération d'écriture, à chaque période d'échantillonnage, la nouvelle valeur entrante est écrite dans la mémoire à l'emplacement indiqué par le pointeur d'écriture. Après cette opération, le pointeur est incrémenté d'une unité pour préparer l'écriture qui interviendra à la période suivante d'échantillonnage. Une détection de fin d'adresse est effectuée pour pae = N et une ré-initialisation du pointeur à l'adresse de début est effectuée.

En ce qui concerne l'opération de lecture, un mécanisme similaire est mis en place, le pointeur de lecture venant extraire la valeur mémorisée à chaque période d'échantillonnage. Le pointeur de lecture pal est incrémenté d'une unité après l'opération de lecture pour préparer la lecture lors de la période d'échantillonnage suivante. La ré-initialisation est effectuée de manière semblable à celle du pointeur d'écriture. Le décalage entre le pointeur d'écriture et le pointeur de lecture définit alors le retard apporté par la mémoire circulaire. On note toutefois, ainsi qu'il sera décrit ci-après dans la description, que plusieurs pointeurs de lecture peuvent être engendrés simultanément afin d'apporter des retards variables sur le signal numérique retardé snr.

Ainsi qu'on l'a représenté en figure 3a, une première variante de réalisation du dispositif de retard programmable, objet de l'invention, permet d'obtenir plusieurs valeurs de retard programmables simultanées par utilisation, à chaque période d'échantillonnage, d'un pointeur d'adresse en écriture pae et d'une pluralité de pointeurs d'adresses en lecture pal sur une même mémoire de retard 2. Dans un tel cas, la mémoire de retard permet de délivrer sur P voies en parallèles, P signaux numériques retardés dont le retard est proportionnel au rang i et à la valeur de l'adresse du pointeur en lecture $pal_i$ de rang correspondant par rapport au pointeur d'écriture.

Dans un tel cas, le circuit 4 de sous-échantillonnage est alors formé par P voies en parallèle, chaque voie de sous-échantillonnage recevant un signal numérique retardé de rang correspondant, noté $snr_1$, $snr_i$ à $snr_P$.

D'une manière générale, on indique que le circuit 4 de sous-échantillonnage peut être formé par une pluralité de filtres de sous-échantillonnage connectés en cascade, notés $4_{ij}$, l'indice i désignant un indice lié au retard effectivement apporté, cet indice i correspondant à l'indice du pointeur de lecture $pal_i$ de la mémoire de retard 2 alors que l'indice j correspond à un indice lié à la valeur de la fréquence obtenue après sous-échantillonnage par le circuit de sous-échantillonnage $4_{ij}$ précité. Les signaux numériques retardés sous-échantillonnés délivrés par chaque voie de sous-échantillonnage de rang i sont notés $snrs_i$. Chaque filtre de sous-échantillonnage de rang j reçoit le signal numérique retardé sous-échantillonné délivré par le filtre de sous-échantillonnage de rang inférieur j-1 à la fréquence $F_{j-i}$, le premier filtre de sous-échantillonnage de chaque voie de sous-échantillonnage recevant bien entendu le signal délivré par la mémoire de retard 2 pour le pointeur d'adresse en lecture $pal_i$ correspondant. Chaque circuit de sous-échantillonnage échantillonnage délivre un signal numérique retardé à une fréquence d'échantillonnage $F_j$ correspondante successivement.

Ainsi, on indique que chaque voie de sous-échantillonnage comprend une pluralité de filtres de sous-échantillonnage connectés en cascade, ceux-ci, sur la figure 3a, portant les références $4_{i2}$ et $4_{i3}$ pour la voie de rang i correspondant, l'indice j dans l'annotation $4_{ij}$ égal à 2 respectivement 3 correspondant à l'indice de la fréquence $F_2$, $F_3$ délivrée par chaque filtre de sous-échantillonnage $4_{i2}$, $4_{i3}$ de chaque filtre correspondant de la voie de sous-échantillonnage i.

Dans les modes de réalisation du dispositif de retard programmable, objet de la présente invention, tel que décrit en figure 2 et 3a, on indique que d'une manière générale, pour obtenir un retard R et en mémorisant les échantillons du signal numérique sn à la fréquence $F_1$, la taille de la mémoire retard 2 doit être égale à une valeur $M = R/T_1$ où $T_1$ représente la période d'échantillonnage du signal numérique sn.

A titre d'exemple, on indique que, pour un retard de 5,12 ms et pour $F_1$ = 4096 kHz, la taille mémoire nécessaire est de 20971 mots, mots de 16 bits par exemple.

Une deuxième variante de réalisation du dispositif de retard programmable, objet de la présente invention, sera maintenant décrite en liaison avec la figure 3b, variante dans laquelle la taille mémoire globale utilisée pour réaliser la mémoire de retard 2 est optimisée, c'est-à-dire rendue minimale pour assurer la fonction de retard souhaité.

Ainsi que représenté sur la figure 3b précitée, on indique que la mémoire de retard 2 est alors répartie en une pluralité de mémoires de retard élémentaires. Par convention, chaque mémoire élémentaire sur la figure 3b porte la référence $2_{j-1}$, l'indice j-1, par commodité, correspondant à l'indice de valeur de fréquence du signal numérique retardé délivré par chaque mémoire élémentaire de rang j-1 au circuit de sous-échantillonnage de rang j, lequel délivre un signal sous-échantillonné à la fréquence fj correspondante.

Ainsi, chaque mémoire élémentaire de rang j-1 reçoit un signal numérique d'entrée à la fréquence $F_{j-1}$ et délivre un signal numérique retardé $snr_{j-1}$ à la fréquence $F_{j-1}$ au filtre de sous-échantillonnage de rang j correspondant, chaque mémoire élémentaire $2_{j-1}$ étant connectée au circuit de sous-échantillonnage $4_j$ correspondant.

La taille mémoire de chaque mémoire de retard élémentaire $2_{j-1}$ de rang j-1 est, conformément à une caractéristique particulièrement avantageuse, proportionnelle au rapport de la fréquence $F_{j-1}$ du signal numérique délivré par cette mémoire de retard élémentaire $2_{j-1}$ et la fréquence $F_j$ du signal numérique retardé sous-échantillonné délivré par le filtre de sous-échantillonnage de rang j qui est connecté à la mémoire de retard élémentaire $2_{j-1}$ précitée.

Pour raison de commodité, sur la figure 3b on a représenté uniquement trois mémoires de retard élémentaires portant les références $2_1$, $2_2$, $2_3$. Celles-ci sont interconnectées entre le convertisseur $\Delta\Sigma_1$ et le circuit de sous-échantillonnage $4_2$, ce circuit de sous-échantillonnage et le circuit de sous-échantillonnage $4_3$, et ce dernier circuit de sous-échantillonnage et la sortie délivrant le signal numérique retardé sous-échantillonné snrs.

Ainsi, dans le mode de réalisation représenté en figure 3b, la taille mémoire de la mémoire de retard élémentaire $2_1$ pour le signal numérique à la fréquence $F_1$, est égale au rapport $F_1/F_2$, soit par exemple $F_1/F_2$ = N. La mémoire élémentaire $2_1$ sert à permettre l'introduction d'un retard d'une valeur inférieure au pas possible à la fréquence $F_2$.

De la même manière, la taille mémoire de la mémoire élémentaire $2_2$, pour le signal numérique à la fréquence $F_2$, est égale au rapport $F_2/F_3$, soit $M = F_2/F_3$. La mémoire élémentaire $2_2$ sert de la même façon à permettre l'introduction d'un retard d'une valeur inférieure au pas possible à la fréquence $F_3$.

La taille mémoire de la mémoire élémentaire $2_3$ est déterminée par la valeur maximale que l'on s'est fixée. Pour toute valeur de retard inférieure à la valeur maximale précitée, il existe une décomposition possible entre les trois mémoires élémentaires, $2_1$, $2_2$, $2_3$, laquelle respecte la valeur de retard désirée à la précision la plus fine près.

Ainsi, pour un retard R donné, on détermine une valeur d'un entier k immédiatement inférieure, multiple de la période d'échantillonnage $T_3$, soit :

$$k.T_3 \leq R < (k+1).T_3.$$

Pour une valeur $R_1$ de la différence entre le retard R spécifié et le retard obtenu, c'est-à-dire :

$$R_1 = R - k.T_3$$

on peut alors déterminer ensuite la valeur m immédiatement inférieure possible multiple de la période d'échantillonnage $T_2$, soit :

$$m.T_2 \leq R_1 < (m+1).T_2.$$

Pour $R_2$ différence entre le retard R1 précité et le retard obtenu vérifiant la relation :

$$R_2 = R_1 - m.T_2$$

on peut alors déterminer la valeur n immédiatement inférieure possible, multiple de la période d'échantillonnage $T_1$, vérifiant la relation :

$$n.T_1 \leq R_2 < (n+1).T_1.$$

Compte tenu des développements précédents, on obtient alors la valeur de retard globale :

$$\text{Retard} = n.T_1 + m.T_2 + k.T_3$$

avec n<N,m<M, où $N = T_2/T_1$, $M = T_3/T_2$.

Dans le mode de réalisation de la figure 3b et pour des valeurs de retard correspondant au mode de réalisation de la figure 2, soit un retard de 5,12 ms et pour $F_1 = 4096$kHz, $F_2 = 256$kHz et $F_3 = 16$kHz, on obtient alors k=81, m=14, n=11.

Les valeurs de k, m et n représentent les tailles mémoire en nombre de mots de chaque mémoire élémentaire $2_3$, $2_2$ et $2_1$.

Ainsi, un total de 106 mots mémoire est nécessaire pour effectuer le retard spécifié, ce nombre total de mots mémoire étant à comparer au 20971 mots mémoire nécessaires dans la mise en oeuvre du dispositif précédemment décrit en liaison avec la figure 2.

Bien entendu, on indique que le nombre de mémoires élémentaires n'est pas limité à trois et qu'il est possible d'augmenter ce nombre si nécessaire.

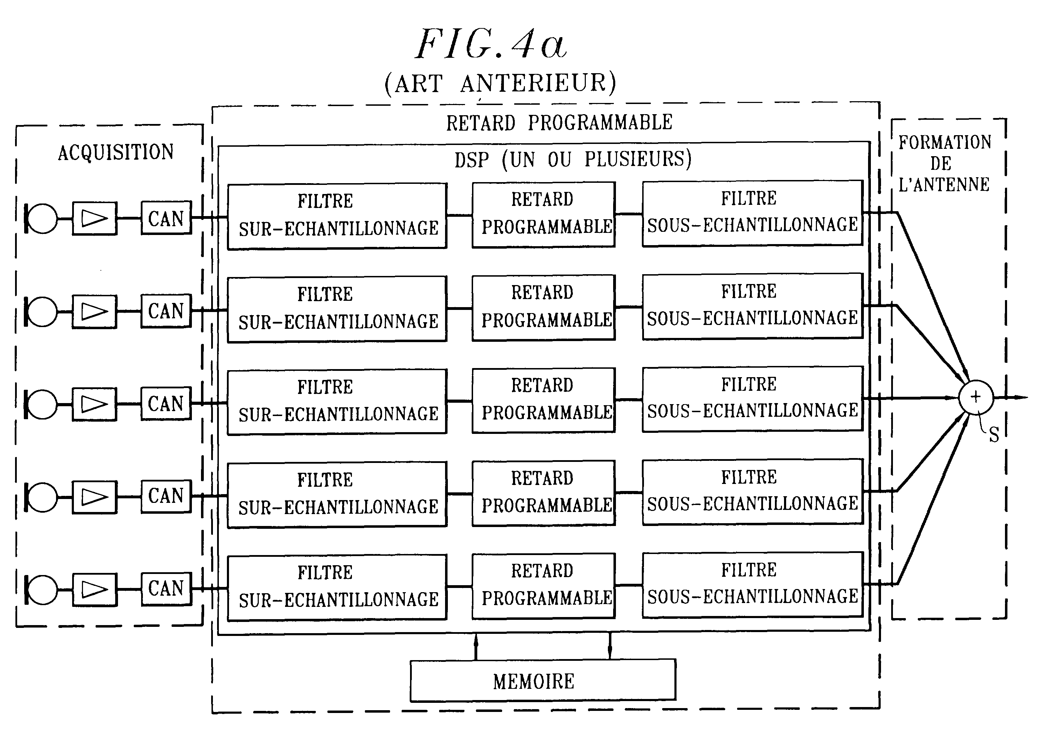

Enfin, sur la figure 4a, on a représenté une antenne acoustique du type à balayage électronique mise en oeuvre au moyen d'un processeur de signal numérique, conformément aux techniques de l'art antérieur.

Dans ce mode de réalisation, cette antenne comprend cinq microphones et correspond à une antenne de type à angle de pointage variable, c'est-à-dire à une antenne du type à balayage électronique.

Elle se décompose en trois éléments distincts :

- une première partie, acquisition des signaux microphoniques, chaque microphone étant relié à un amplificateur analogique et à un convertisseur analogique numérique de type classique, tel que précédemment décrit dans la description, dans l'introduction,
- une seconde partie, retard programmable,
- une troisième partie, formation de l'antenne.

Pour la partie retard programmable, la technique classique consiste à utiliser un ou plusieurs processeurs numériques de signal numérique, cette technique classique introduisant toutefois les dégradations du signal précédemment mentionnées dans la description.

Sur la figure 4b, on a représenté au contraire la même antenne, réalisée grâce à la mise en oeuvre de dispositifs de retard conformes à l'objet de la présente invention, celle-ci comportant les microphones associés à leur amplificateur analogique et notés $m_i$, chaque dispositif de retard programmable, noté $V_1$ à $V_N$, conforme à l'objet de la présente invention, étant directement connecté en sortie de chaque amplificateur analogique correspondant.

Le mode de réalisation tel que décrit en figure 4b permet d'effectuer la même fonction de retard pur sans aucune introduction de dégradation du signal.

D'une manière générale, les dispositifs de retard programmable conformes à l'objet de la présente invention, peuvent être utilisés dans tous types d'antenne acoustique programmable, que celle-ci soit utilisée comme antenne à angle de pointage variable ou, au contraire, comme antenne pour laquelle un diagramme de réception spécifique est recherché.

D'une manière plus générale, le dispositif de retard programmable, objet de la présente invention, peut être utilisé dans toute application nécessitant l'introduction de retard avec une précision inférieure au temps séparant deux échantillons successifs après échantillonnage, grâce à l'utilisation d'un convertisseur analogique numérique de type $\Delta\Sigma$.

La mise en oeuvre de dispositifs de retard programmable conformes à l'objet de la présente invention, permet de s'affranchir de tous les problèmes rencontrés lorsqu'il est nécessaire d'utiliser la fonction de retard mise en oeuvre au moyen de processeurs de traitement de signal et à la contrainte correspondante due à la nécessaire limitation de la longueur des filtres utilisés, ce qui a pour conséquence une dégradation des signaux soumis à ce type de traitement, nécessité de traiter même les signaux ne nécessitant pas de retard et retard global important dans la chaîne du fait de la présence de filtres numériques.

En outre, on indique que la mise en oeuvre des dispositifs de retard programmable, selon l'invention, est alors réalisée pour un prix de revient modique, ce d'autant plus que la taille mémoire nécessaire peut être optimisée ainsi que décrit précédemment dans la description.

## Revendications

1. Dispositif de retard programmable d'un signal analogique, caractérisé en ce qu'il comprend au moins :

   - un circuit convertisseur analogique/numérique (1) recevant ledit signal analogique et délivrant un signal numérique à une première fréquence d'échantillonnage, succession d'échantillons ;
   - une mémoire de retard (2) recevant en écriture ledit signal numérique et permettant la mémorisation de M échantillons consécutifs ;
   - des moyens d'accès en écriture (PAE) et en lecture (PAL) de ladite mémoire de retard permettant d'adresser en écriture et en lecture ladite mémoire de retard avec une fréquence d'écriture et de lecture égale à la première fréquence d'échantillonnage, ladite mémoire de retard délivrant sur commande d'accès en lecture une suite d'échantillons retardés d'une valeur déterminée, fonction du nombre d'échantillons mémorisés M dans ladite mémoire de retard, par rapport à la succession d'échantillons reçus pour écriture à l'entrée de ladite mémoire de retard, lesdits échantillons retardés formant un signal numérique retardé ;
   - des moyens de sous-échantillonnage (4) recevant ledit signal numérique retardé et délivrant un signal numérique retardé sous-échantillonné à une deuxième fréquence d'échantillonnage, inférieure à la première fréquence d'échantillonnage.

2. Dispositif selon la revendication 1, caractérisé en ce que lesdits moyens d'accès en écriture et en lecture délivrent simultanément à ladite mémoire de retard un pointeur d'adresse en écriture et au moins un pointeur d'adresse en lecture, la différence des adresses desdits pointeurs étant égale au nombre $M_i$ d'échantillons mémorisés, le retard introduit par ladite mémoire de retard étant égal au produit du nombre $M_i$ d'échantillons mémorisés entre le pointeur d'adresse en écriture et ledit au moins un pointeur d'adresse en lecture et de la période $T_1$ inverse de la première fréquence d'échantillonnage $F_1$.

3. Dispositif selon la revendication 2, caractérisé en ce que lesdits moyens d'accès en écriture et en lecture délivrent simultanément à ladite mémoire de retard :

   - un pointeur d'adresse en écriture (pae) ;
   - une pluralité de pointeurs d'adresse en lecture ($pal_i$), avec $i \in [1,P]$, ladite mémoire de retard permettant de délivrer sur P voies en parallèle P signaux numériques retardés dont le retard est proportionnel au rang i et à la valeur de l'adresse du pointeur en lecture de rang correspondant, et en ce que lesdits moyens de sous-échantillonnage sont formés par P voies en parallèle, chaque voie de sous-échantillonnage recevant un signal numérique retardé de rang correspondant.

4. Dispositif selon l'une des revendications 1 à 3 précédentes, caractérisé en ce que ledit circuit convertisseur analogique/numérique est un convertisseur comportant une pluralité d'étages de conversion en cascade pilotés chacun par une fréquence d'échantillonnage différente.

5. Dispositif selon l'une des revendications 1 à 4, caractérisé en ce que lesdits moyens de sous-échantillonnage sont formés par une pluralité de filtres de sous-échantillonnage connectés en cascade, chaque filtre de sous-échantillonnage de rang j recevant le signal numérique retardé sous-échantillonné délivré par le filtre de sous-échantillonnage de rang inférieur j-1, à la fréquence $F_{j-1}$ et délivrant un signal numérique retardé sous-échantillonné à une fréquence d'échantillonnage $F_j$, successivement.

6. Dispositif selon la revendication 5, caractérisé en ce que ladite mémoire de retard est une mémoire répartie en une pluralité de mémoires de retard élémentaires, une mémoire élémentaire de rang j-1 recevant un signal numérique d'entrée à la fréquence $F_{j-1}$ et délivrant un signal numérique retardé à la fréquence $F_{j-1}$ au filtre de sous-échantillonnage de rang j correspondant, auquel ladite mémoire de retard élémentaire est connectée, la taille mémoire de chaque mémoire de retard élémentaire de rang j-1 étant proportionnelle au rapport de la fréquence $F_{j-1}$ du signal numérique délivré par ladite mémoire de retard élémentaire et de la fréquence $F_j$ du signal numérique retardé délivré par le filtre de sous-échantillonnage de rang j, qui est connecté à ladite mémoire de retard élémentaire.

7. Antenne acoustique programmable, caractérisée en ce qu'elle comprend une pluralité de voies en parallèle interconnectées à un circuit sommateur commun, chaque voie comportant, en cascade :

- un transducteur acoustique interconnecté à un amplificateur, et
- un dispositif de retard programmable selon l'une des revendications 1 à 6 précédentes, interconnecté entre l'amplificateur et ledit circuit sommateur commun.

**Patentansprüche**

1. Vorrichtung zur einstellbaren Verzögerung eines analogen Signals, **dadurch gekennzeichnet**, daß sie wenigstens umfaßt:

   - einen Analog/Digital-Wandlerschaltkreis (1), der das analoge Signal empfängt und ein digitales Signal einer Folge von Abtastwerten mit einer ersten Abtastfrequenz liefert;
   - einen Verzögerungsspeicher (2), der das digitale Signal zum Schreiben empfängt und die Speicherung von M aufeinanderfolgenden Abtastwerten erlaubt;
   - Mittel zum Schreibzugriff (PAE) und zum Lesezugriff (PAL) auf den Verzögerungsspeicher, die eine Schreibadressierung und eine Leseadressierung des Verzögerungsspeichers mit einer Schreib- und Lesefrequenz erlauben, die gleich der ersten Abtastfrequenz ist, wobei der Verzögerungsspeicher auf einen Lesezugriffsbefehl hin eine Folge von Abtastwerten liefert, welche bezüglich der Folge der am Eingang des Verzögerungsspeichers zum Schreiben empfangenen Abtastwerte um einen bestimmten Wert als Funktion der Zahl von im Verzögerungsspeicher gespeicherten Abtastwerten M verzögert sind, wobei die verzögerten Abtastwerte ein verzögertes digitales Signal bilden;
   - Mittel zur Unterabtastung (4), die das verzögerte digitale Signal empfangen und ein verzögertes digitales Signal liefern, welches mit einer zweiten Abtastfrequenz unterabgetastet ist, die kleiner als die erste Abtastfrequenz ist.

2. Vorrichtung nach Anspruch 1, **dadurch gekennzeichnet**, daß die Schreib- und Lesezugriffsmittel dem Verzögerungsspeicher gleichzeitig einen Schreibadressenzeiger und wenigstens einen Leseadressenzeiger liefern, wobei die Differenz der Adressen der Zeiger gleich der Zahl Mi gespeicherter Abtastwerte ist, wobei die durch den Verzögerungsspeicher eingeführte Verzögerung gleich dem Produkt ist der Zahl Mi von zwischen dem Schreibadressenzeiger und dem wenigstens einen Leseadressenzeiger gespeicherten Abtastwerten und der Periode $T_1$, die zur ersten Abtastfrequenz $F_1$ invers ist.

3. Vorrichtung nach Anspruch 2, **dadurch gekenn-**

**zeichnet**, daß die Schreib- und die Lesezugriffsmittel dem Verzögerungsspeicher gleichzeitig liefern:

   - einen Schreibadressenzeiger (pae);
   - eine Mehrzahl von Leseadressenzeigern (pal) mit i $\in$ [1,P], wobei es der Verzögerungsspeicher ermöglicht, auf P Wegen parallel P verzögerte digitale Signale zu liefern, deren Verzögerung proportional zum Rang i und zum Adressenwert des Lesezeigers entsprechenden Rangs ist, und daß die Unterabtastmittel durch P parallele Wege gebildet sind, wobei jeder Unterabtastweg ein verzögertes digitales Signal entsprechenden Rangs empfängt.

4. Vorrichtung nach einem der vorhergehenden Ansprüche 1 bis 3, **dadurch gekennzeichnet**, daß der Analog/Digital-Wandlerschaltkreis ein Wandler ist, der eine Mehrzahl von Wandlerstufen in Kaskade enthält, welche jeweils durch eine unterschiedliche Abtastfrequenz gesteuert werden.

5. Vorrichtung nach einem der Ansprüche 1 bis 4, **dadurch gekennzeichnet**, daß die Unterabtastmittel durch eine Mehrzahl von in Kaskade angeschlossenen Unterabtastfiltern gebildet sind, wobei jeder Unterabtastfilter mit Rang j das durch den Unterabtastfilter mit kleinerem Rang j-1 gelieferte digitale verzögerte unterabgetastete Signal mit der Frequenz $F_{j-1}$ empfängt und nachfolgend ein digitales verzögertes unterabgetastetes Signal mit einer Abtastfrequenz $F_j$ liefert.

6. Vorrichtung nach Anspruch 5, **dadurch gekennzeichnet**, daß der Verzögerungsspeicher ein auf eine Mehrzahl von Elementarverzögerungsspeichern verteilter Speicher ist, wobei ein Elementarspeicher mit Rang j-1 ein digitales Eingangssignal mit der Frequenz $F_{j-1}$ empfängt und ein digitales verzögertes Signal mit der Frequenz $F_{j-1}$ an den zugeordneten Unterabtastfilter mit Rang j liefert, an den der Elementarverzögerungsspeicher angeschlossen ist, wobei die Speichergröße jedes Elementarverzögerungsspeichers mit Rang j-1 proportional ist zum Verhältnis zwischen der Frequenz $F_{j-1}$ des vom Elementarverzögerungsspeicher gelieferten digitalen Signals und der Frequenz Fj des verzögerten digitalen Signals, das durch den Unterabtastfilter mit Rang j geliefert wird, welcher an den Elementarverzögerungsspeicher angeschlossen ist.

7. Einstellbare akustische Antenne, **dadurch gekennzeichnet**, daß sie eine Mehrzahl von parallelen Wegen umfaßt, die an einen gemeinsamen Summierschaltkreis angeschlossen sind, wobei jeder Weg in Kaskade umfaßt:

   - einen an einen Verstärker angeschlossenen akustischen Wandler, und

- eine Vorrichtung zur einstellbaren Verzögerung nach einem der vorhergehenden Ansprüche 1 bis 6, die zwischen dem Verstärker und dem gemeinsamen Summierschaltkreis angeschlossen ist.

**Claims**

1. Device for programmable delay of an analog signal, characterized in that it comprises at least:

   - an analog/digital converter circuit (1) receiving the said analog signal and delivering a digital signal at a first sampling frequency, a succession of samples;
   - a delay memory (2) receiving the said digital signal in write mode and allowing memory storage of M consecutive samples;
   - means for write (PAE) and read (PAL) access to the said delay memory making it possible to address the said delay memory, in write and read mode, with a write and read frequency equal to the first sampling frequency, the said delay memory delivering, under read access control, a series of samples delayed by a defined value, which is a function of the number of samples M stored in the said delay memory, with respect to the succession of samples received for writing at the input of the said delay memory, the said delayed samples forming a delayed digital signal;
   - sub-sampling means (4) receiving the said delayed digital signal and delivering a sub-sampled delayed digital signal at a second sampling frequency, lower than the first sampling frequency.

2. Device according to Claim 1, characterized in that the said write and read access means simultaneously deliver, to the said delay memory, a write address pointer and at least one read address pointer, the difference in the addresses of the said pointers being equal to the number $M_i$ of samples stored in memory, the delay introduced by the said delay memory being equal to the product of the number $M_i$ of samples stored in memory between the write address pointer and the said at least one read address pointer and of the period $T_1$ which is the inverse of the first sampling frequency $F_1$.

3. Device according to Claim 2, characterized in that the said write and read access means simultaneously deliver to the said delay memory:

   - a write address pointer (pae);
   - a plurality of read address pointers ($pal_i$) with i

$\in$ [1,P], the said delay memory making it possible to deliver, on P channels in parallel, P delayed digital signals, the delay of which is proportional to the level i and to the value of the address of the read pointer of corresponding level, and in that the said sub-sampling means are formed by P channels in parallel, each sub-sampling channel receiving a delayed digital signal of corresponding level.

4. Device according to one of the preceding Claims 1 to 3, characterized in that the said analog/digital converter circuit is a converter including a plurality of conversion stages in cascade each driven by a different sampling frequency.

5. Device according to one of Claims 1 to 4, characterized in that the said sub-sampling means are formed by a plurality of sub-sampling filters connected in cascade, each sub-sampling filter of level j receiving the sub-sampled delayed digital signal delivered by the sub-sampling filter of lower level j-1, at the frequency $F_{j-1}$, and delivering a sub-sampled delayed digital signal at a sampling frequency Fj, successively.

6. Device according to Claim 5, characterized in that the said delay memory is a memory distributed into a plurality of elementary delay memories, an elementary memory of level j-1 receiving an input digital signal at the frequency $F_{j-1}$ and delivering a delayed digital signal at the frequency $F_{j-1}$ to the corresponding level-j sub-sampling filter, to which the said elementary delay memory is connected, the memory size of each elementary delay memory of level j-1 being proportional to the ratio of the frequency $F_{j-1}$ of the digital signal delivered by the said elementary delay memory and of the frequency $F_j$ of the delayed digital signal delivered by the level-j sub-sampling filter, which is connected to the said elementary delay memory.

7. Programmable acoustic antenna, characterized in that it comprises a plurality of channels in parallel, interconnected to a common summer circuit, each channel including, in cascade:

   - an acoustic transducer interconnected to an amplifier, and
   - a programmable delay device according to one of the preceding Claims 1 to 6, interconnected between the amplifier and the said common summer circuit.

## FIG.1a
### (ART ANTERIEUR)

$F_1$ | FILTRE DE SUR ECHANTILLONNAGE | $F_2$ | RETARD M*1/$F_2$ | $F_2$ | FITRE DE SOUS ECHANTILLONNAGE | $F_1$

A/D

## FIG.1b
### (ART ANTERIEUR)

DSP

X(nT) → FILTRE DE SUR ECHANTILLONNAGE → POINTEUR ECRITURE ECHANTILLONS → MEMOIRE EXTERNE

X(n–N)T ← FITRE DE SOUS ECHANTILLONNAGE ← POINTEUR LECTURE ECHANTILLONS ←

## FIG.1c
### (ART ANTERIEUR)

CONVERTISSEUR $\Delta\Sigma$ n1 BITS | $F_1$ | FILTRE DE SOUS ECHANTILLONNAGE | $F_2$ | FILTRE DE SOUS ECHANTILLONNAGE | $F_3$

TYP : n1 = 2BITS     $F_1 = 16* F_2$     $F_2 = 16* F_3$

# FIG.2

# FIG.4b

FIG.3a

FIG.3b

# FIG.4α

## (ART ANTERIEUR)

RETARD PROGRAMMABLE

ACQUISITION

DSP (UN OU PLUSIEURS)

FORMATION DE L'ANTENNE

| | | |
|---|---|---|
| FILTRE SUR-ECHANTILLONNAGE | RETARD PROGRAMMABLE | FILTRE SOUS-ECHANTILLONNAGE |
| FILTRE SUR-ECHANTILLONNAGE | RETARD PROGRAMMABLE | FILTRE SOUS-ECHANTILLONNAGE |
| FILTRE SUR-ECHANTILLONNAGE | RETARD PROGRAMMABLE | FILTRE SOUS-ECHANTILLONNAGE |
| FILTRE SUR-ECHANTILLONNAGE | RETARD PROGRAMMABLE | FILTRE SOUS-ECHANTILLONNAGE |
| FILTRE SUR-ECHANTILLONNAGE | RETARD PROGRAMMABLE | FILTRE SOUS-ECHANTILLONNAGE |

CAN

+

S

MEMOIRE

EP 0 740 414 B1